# EUROPÄISCHE PATENTSCHRIFT

(11) **EP 2 797 121 B1**
(45) Veröffentlichungstag und Bekanntmachung des Hinweises auf die Patenterteilung: **13.12.2017**
(21) Anmeldenummer: 14401047.7
(22) Anmeldetag: 22.04.2014
(51) Int. Cl.: H01L 31/048

(54) **Bypassanordnung in einem Glas-Glas-Solarmodul-Laminat mit Solarzellen**
Bypass arrangement in a glass-glass solar module laminate with solar cells
Dispositif de dérivation dans un laminé de module solaire verre-verre à cellules solaires

(30) Priorität: 23.04.2013 DE 102013104109; 17.04.2014 DE 102014105598
(43) Veröffentlichungstag der Anmeldung: 29.10.2014
(73) Patentinhaber: Solarwatt GmbH, 01109 Dresden (DE)
(72) Erfinder: Uhlmann, Rüdiger, 01109 Dresden (DE); Friedrich, Steffen, 01474 Radeberg (DE); Künanz, Steffen, 01987 Schwarzheide (DE); Lippmann, Robert, 01217 Dresden (DE)
(74) Vertreter: Kruspig, Volkmar

(56) Entgegenhaltungen:
- US-A1- 2010 147 364
- US-A1- 2013 050 227

## Beschreibung

Die Erfindung betrifft eine Bypassanordnung in einem Glas-Glas-Solarmodul-Laminat mit innen liegenden Solarzellen mit oder ohne Rahmen.

Solarmodul-Laminate bestehen aus einer Frontglasscheibe und einer Rückseitenfolie oder aus einer Frontglasscheibe und einer Rückglasscheibe, zwischen denen sich die aktiven Solarzellen, die elektrische Verbindungen und das Einbettungsmaterial befinden. Das Einbettungsmaterial wird vor dem Laminieren meist in der Form von zwei Folien (zwei Lagen) zugeführt und beigelegt, wobei die Abmessungen mit den Abmessungen der beiden Glasscheiben übereinstimmen. Die Lagen werden in der Regel hinter und vor den Solarzellen und den elektrischen Verbindungselementen angeordnet. Die Zellen sind elektrisch in der Regel in Reihe geschalten, wobei die beiden Enden der Reihenschaltung aller Zellen außen an gegenüberliegenden Modulkanten angeordnet sind und die inneren Modulanschlüsse darstellen. Diese inneren Modulanschlüsse sind meist durch relativ lange innere Verbindungsleitungen bis in die Nähe der Modulmitte geführt und durch die Rückseitenfolie bei Glas-Folien-Solarmodulen oder Rückglasscheibe hindurch auf der Rückseite des Moduls in einer externen außen angeordneten zentralen Anschlussdose zusammengeführt. Innerhalb der Anschlussdose sind die üblicherweise relativ großen Bypasselemente, wie Halbleiterdioden mit radialen oder axialen Anschlüssen, oder kleinere monolithische oder hybride Halbleiterdioden-Ersatzschaltungen, teilweise mit zusätzlichen Kühlelementen zur besseren Wärmeableitung aus dem Bypasselement im Innenraum der Anschlussdose, untergebracht und elektrisch angeschlossen.

Jedes Bypasselement ist elektrisch nur über einen bestimmten Teil der Reihenschaltung aller einzelnen Solarzellen geschaltet, in der Regel über je 20 Solarzellen eines Moduls bei sogenannten 60 Zellen-Modulen. Die Bypasselemente dienen dem Zweck, im Falle von teilweisen Verschattungen des Solarmoduls die abgegebene Modulleistung so hoch wie möglich zu halten, da sonnst im Extremfall, obwohl nur wenige Einzelzellen beschattet sind alle Zellen des Moduls keinen Strom erzeugen. Gleichzeitig sollen sie Überhitzungen zuverlässig vermeiden um die aktiven Solarzellen vor einer Zerstörung zu bewahren.

Bei der Herstellung von Solarmodulen mit Rückseitenfolien ist es bekannt, dass sich das Material der Rückseitenfolie während des Laminierprozesses ab etwa 150 C beginnt plastisch zu verformen. Damit kann sich die Form der Rückseitenfolie der Kontur zwischen liegender Bypasselemente mit den angeschlossenen Querverbindern anpassen. Bei zu großen Gesamthöhen der Bypasselemente besteht jedoch das Risiko, dass sich die Rückseitenfolie nicht ausreichend weit verformt, so dass im Bereich der Bypasselemente größere Hohlräume ohne Einbettungsmaterial entstehen, die letztlich die Zuverlässigkeit dieser Module einschränken können.
Die elektrischen Verbindungen der Bypasselemente und der äußeren Modulanschlüsse in der Anschlussdose mit den jeweiligen elektrischen Kontaktpunkten in der Reihenschaltung aller Zellen, erfolgen über lange und ggf. zusätzliche Verbindungsleitungen durch die Rückseitenfolie oder Rückglasscheibe hindurch und erfordern daher mindestens 12 Kontakte innerhalb einer Anschlussdose pro Solarmodul. Diese Kontakte können wahlweise z.B. als Löt-, Schweiß- oder Klemmverbindungen ausgebildet sein.
Alle elektrischen Kontaktpunkte für die Bypasselemente liegen üblicherweise an einem Rand der Zellenmatrix, an dem zugleich flache Querverbinder angeordnet sind, mit denen alle Zellenverbinder jeder dort befindlichen Randzelle elektrisch parallel geschaltet sind. Die Anschlussdosen dienen der sicheren mechanischen Verankerung und dem Schutz gegen klimatische Einflüsse aller darin endenden elektrischen Verbindungsleitungen aus dem Modulinneren und der beiden Modulanschlussleitungen nach außen, sowie aller dazu notwendigen elektrischen Kontaktverbindungen. Das Dokument US-A-2010/0147364 zeigt ein Solarmodul mit einer Frontglasscheibe und einer Rückglasscheibe und dazwischen liegenden Solarzellen und Bypassdioden. Die Anschlussdosen tragen insbesondere mit ihrer ausliegenden Bodenplatte, sowie dem notwendigen Befestigungsmaterial in dem Bereich, in dem diese auf dem Solarmodul angeordnet und befestigt sind, zur verstärkten Erwärmung der dort befindlichen aktiven Solarzellen bei, da an dieser Stelle die Rückseitenfläche nicht gekühlt werden kann. Bypasselemente entwickeln zudem auch eigene zusätzliche Verlustwärme, die spätestens bei vollständiger Verschattung einer einzigen Zelle einen Maximalwert erreicht. Diese Verlustwärme trägt infolge Wärmestau insbesondere zur Erwärmung der gesamten Anschlussdose bei, da eine Belüftung der Anschlussdose zur Wärmeabfuhr aus Gründen des klimatischen Schutzes und aus Kostengründen nicht möglich ist. Durch diesen Wärmestau erhitzen sich die angeordneten Bypasselemente sehr stark, insbesondere das jeweils in der Mitte angeordnete, der drei notwendigen Bypasselemente, was ein gewisses Überhitzungsrisiko darstellt.

Solarzellen weisen bekannterweise einen negativen Temperaturkoeffizienten auf, d.h. der Wirkungsgrad der Umwandlung von Sonnenlicht in elektrische Energie sinkt mit wachsender Temperatur. In den meisten Anwendungsfällen werden Solarmodule im Solarmodulverbund angeordnet und genutzt, d. h. die Solarmodule sind ziemlich dicht nebeneinander in Zeilen und Spalten angeordnet. In der Regel werden die Modulanschlüsse vieler in der gleichen Zeile angeordneter Module elektrisch in Reihe untereinander verschaltet. Die notwendige Leitungslänge zwischen zentralen Anschlussdosen benachbarter Module beträgt damit immer etwas mehr als eine Solarmodulbreite.

Dieser Aufbau und die Anordnung der Bypässe und deren wie vorstehend beschriebene Verschaltung führen zu folgenden Nachteilen:
- relativ lange, und ggf. zusätzliche Verbindungsleitungen zwischen Bypasselementen und Anschlussdose (erhöhter Aufwand und größere elektrische Verluste)
- relativ lange Verbindungsleitungen der inneren Modulanschlüsse vom Modulrand bis in Nähe der Modulmitte zur tatsächlichen Position der Anschlussdose (erhöhter Aufwand, größere elektrische Verluste)
- hohe Kontaktanzahl von mindestens 12 Kontaktverbindungen pro Modul innerhalb einer Anschlussdose zur Verbindung der Bypasselemente, sowie der inneren und äußeren Modulanschlüsse notwendig (Zuverlässigkeitsrisiko der Kontakte, erhöhter Aufwand)
- die Leitungslänge zwischen zentral angeordneten Anschlussdosen benachbarter Module beträgt mindestens etwas mehr als die Modulbreite und ist damit relativ groß (dies bedingt einen erhöhter Aufwand und größere elektrische Verluste)
- Anschlussdosen mit großen Abmessungen erforderlich, verursacht durch viele Kontaktverbindungen sowie die drei Bypasselemente, dies führt zur Verschlechterung des Modulwirkungsgrades infolge Wärmeisolation und Eigenerwärmung mit Wärmestau
- Überhitzungsrisiko der Bypasselemente infolge Wärmestau innerhalb Anschlussdose
- Vorgefertigte relativ lange Stränge von Bypasselementen und Querverbindern, diese sind biegeempfindlich und schwierig zu handhaben

Der Erfindung liegt die Aufgabe zu Grunde ein Solarmodul-Laminat zu schaffen, bei dem die Länge der Verbindungsleitungen zwischen den Bypasselementen und der Anschlussdose reduziert wird, relativ lange Verbindungsleitungen der inneren Modulanschlüsse vom Modulrand bis in die Nähe der Modulmitte zur Anschlussdose hin vermieden werden, die Kontaktanzahl pro Modul innerhalb Anschlussdose zur Verbindung der Bypasselemente sowie der inneren und äußeren Modulanschlüsse reduziert wir, die Leitungslänge zwischen den Anschlussdosen benachbarter im Verbund verlegter Solarmodule weiter verringert wird und sich der Modulwirkungsgrad und die Lebensdauer weiter erhöht.

Die Aufgabe der Erfindung wird mit den Merkmalen des Hauptanspruches gelöst. Weitere vorteilhafte Ausgestaltungen sind Gegenstand der rückbezüglichen Unteransprüche. Erfindungsgemäß können bei der neuartigen Bypassanordnung in einem Glas-Glas-Solarmodul-Laminat mit innen liegenden Solarzellen, d. h. eingebetteten Solarzellen, mit mehreren kontaktierten Schaltelementen mit oder ohne Rahmen und mit üblichen Anschlussleitungen und Anschlussdosen, zwischen einer Frontglasscheibe 12 und einer Rückglasscheibe 13 in Abhängigkeit von ihrer Dicke mehrere Bypasselemente 1, 6, 14 oder 23 mit unterschiedlicher Höhe angeordnet werden. Bei Bypasselementen die eine größere Dicke als 1,3 mm besitzen, wie beispielsweise bei den dicker als 1,3 mm ausgebildeten Bypasselementen 14 oder 23 sind im Rückseitenglas 13 zusätzliche Aussparungen oder Öffnungen 20 angeordnet. Die Öffnungen 20 können zum Beispiel mittels geeigneter Bohrverfahren hergestellt werden. Die Aussparungen 20 können je nach Bedarf auch eingeätzt oder eingefräst ausgebildet werden. In diesen Öffnungen oder Aussparungen 20 sind dann vorrangig die zu dicken Bypasselemente 14 oder 23 positioniert und mit den entsprechenden Querverbindern 4 kontaktiert. Dabei sind die Bypasselemente 1, 6, 14 oder 23 jeweils in der Längsachse derjenigen zwei Querverbinder 4, 5 oder 21 angeordnet und positioniert, die ihren elektrischen Kontaktpunkten entsprechen und es sind wenigstens zwei Anschlussdosen außen an den Modulrändern angeordnet.

Bei einer besonderen vorteilhaften Ausführung des Glas-Glas-Solarmodul-Laminats sind die Dicken der verschalteten Bypasselemente kleiner gleich 1,3 mm. Dies führt zu einer besonders flachen Bauweise solch eines Glas-Glas-Solarmodul-Laminats. In einer speziellen Ausführung ist der Zwischenraum zwischen der Frontglasscheibe 12 und der Rückglasscheibe 13 bei einem solchen Glas-Glas-Solarmodul-Laminat kleiner gleich 1mm.

In einer anderen Ausführung des erfindungsgemäßen Glas-Glas-Solarmodul-Laminats sind die zusätzlichen Aussparungen 20 nur Innen in der Rückglasscheibe 13 oder nur in Innen in der Frontglasscheibe 12 oder sowohl in der Frontglasscheibe 12 als auch in der Rückglasscheibe 13 als flächige, beliebig geformte, nicht nach außen durchgehende Aussparungen ausgebildet. In diesen Aussparungen sind dann die verbundenen Bypasselemente 14 eingelegt und positioniert. Diese Ausführung ist zwar in der Herstellung etwas aufwändiger, da an den entsprechenden Stellen in der Frontglasscheibe 12 oder in der Rückglasscheibe 13 oder in beiden Scheiben 21, 13 die Aussparungen mit geeigneten Verfahren einzubringen sind. Da diese Art von Aussparungen nicht als durchgehende Öffnungen ausgebildet sind, bleib das gesamte Solarmodul dauerhaft gekapselt und als ganzes nach dem Laminierprozess dicht gegenüber irgendwelchen von außen einwirkenden Umwelteinflüssen.

Von Vorteil ist es Weiterhin wenn zwischen der Frontglasscheibe 12 und der Rückglasscheibe 13 Abstandshalter angeordnet und positioniert sind, deren Dicke kleiner gleich dem Abstand zwischen der Frontglasscheibe 12 und der Rückglasscheibe 13 ist.

Beim neuartigen Verfahren zur Herstellung eines Glas-Glas-Solarmodul-Laminats werden die Solarzellen auf das, mit mindestens einer Lage Einbettungsmaterial 15 und/odere 16 versehene Frontglasscheibe 12 oder das mit mindestens einer Lage Einbettungsmaterial 15 und/oder 16 versehnen Rückglasscheibe 13 aufgelegt und positioniert. Anschließend werden die jeweils einzusetzenden Bypasselemente 1, 6, 14 oder 23 und je nach Bedarf die zugehörigen Querverbinder 4, 5 oder 21 einzeln oder teilweise in vorgefertigten Teilsträngen aufgelegt und positioniert. Bevorzugt sind dabei die Querverbinder 4, 5 oder 21 mit zusätzlich beigelegten Abstandshaltern 18 in ihrer Lage genau positioniert. Im Anschluss erfolgt dann das Kontaktieren aller Bauteile untereinander. In der Regel erfolgt das Kontaktieren mittels geeigneter Lötprozesse. Die Abstandshalter können wahlweise gegebenenfalls auch wieder entfern werden. Dann werden ein, zwei oder mehrere Lagen Einbettungsmaterial 15 bzw. 16 aufgelegt. Nunmehr kann die noch fehlende Rückglasscheibe 13, oder das je nach Art des gewählten Fertigungsverfahrens, die Frontglasscheibe 12 aufgelegt werden. Zum Schluss erfolg dann das Laminieren nach einem der bekannten, in der Branche üblichen, Laminierprozesse.

Durch die erfindungsgemäße Bypassanordnung und das neuartige Verfahren zur Herstellung des Glas-Glas-Solarmodul-Laminat wird es möglich die Länge der Verbindungsleitungen zwischen den Bypasselementen und der Anschlussdose erheblich zu reduzieren. Es gelingt die bislang relativ langen Verbindungsleitungen der inneren Modulanschlüsse vom Modulrand bis in die Nähe der Modulmitte zur Anschlussdose hin zu vermeiden. Des Weitern wird die Kontaktanzahl pro Modul innerhalb jeder Anschlussdose zur Verbindung der Bypasselemente sowie der inneren und äußeren Modulanschlüsse verringert. Insgesamt kann auch die Leitungslänge zwischen den Anschlussdosen benachbarter im Verbund verlegter Solarmodule erheblich weiter verringert werden. Durch die technische Lösung kann ebenfalls der Modulwirkungsgrad gesteigert und die Lebensdauer weiter erhöht werden. Zudem sinkt das Risiko, dass sich einzelne Solarzellen oder ganze Bereiche innerhalb des neuartigen Glas-Glas-Solarmodul-Laminats überhitzen und damit für immer bei der Energieerzeugung ausfallen, d. h. die Modullebensdauer wird verbessert.

Weitere Einzelheiten, Merkmale und Vorteile der Erfindung ergeben sich aus der nachfolgenden Beschreibung von Ausführungsbeispielen mit Bezugnahme auf die zugehörigen Zeichnungen. Es zeigen:
- Fig. 1: zeigt ein Bypasselement 1 als ein Halbleiter-Diodenchip mit einem aufliegenden flachen lötfähigen Querverbinder 5 und einem unteren normalen lötfähigen Querverbinder 4
- Fig. 2: zeigt ein Bypasselement 6 als eine Dioden-Ersatzschaltung mit Kunststoffkapselung mit seitlich herausgeführten abgestuften Anschlussflächen 7 mit aufliegenden normal flachen lötfähigen Querverbindern 4
- Fig. 3: zeigt ein Bypasselement als eine Dioden-Ersatzschaltung mit Kunststoffkapselung mit nebenliegenden Querverbindern 4 und biegsamen lötfähigen Anschlussfahnen 9
- Fig. 4: zeigt einen Querschnitt durch ein Glas-Glas-Solarmodul-Laminat vor dem Laminieren mit einer Einbettungsmateriallage 16 über die gesamte Modulbreite aber kürzer ausgeführt als die Gesamtlänge des Solarmoduls
- Fig. 5: zeigt einen Querschnitt durch ein Glas-Glas-Solarmodul-Laminat nach dem Laminieren mit einer Einbettungsmateriallage 16 über die gesamte Modulbreite aber kürzer ausgeführt als die Gesamtlänge des Solarmoduls
- Fig. 6: zeigt eine Draufsicht auf eine Ausführung gemäß Figur 4
- Fig. 7: zeigt einen neuartigen Abstandshalter 18 vor dem Laminieren eingebettet und umschlossen von Einbettungsmaterial 15
- Fig. 8: zeigt einen neuartigen Abstandshalter 18 nach dem Laminieren anliegend an der Frontglasscheibe 12 und der Rückglasscheibe 13
- Fig. 9: zeigt eine Draufsicht nach Figur 4 und Figur 6
- Fig. 10: zeigt ein geringfügig zu dickes Bypasselement 14 und dessen Anordnung in einer zusätzlich eingebrachten Öffnung 20 in der Rückglasscheibe 20
- Fig. 11: zeigt ein dickeres Bypasselement 23 und dessen Anordnung in einer zusätzlich eingebrachten Aussparung oder Öffnung 20 in der Rückglasscheibe 13

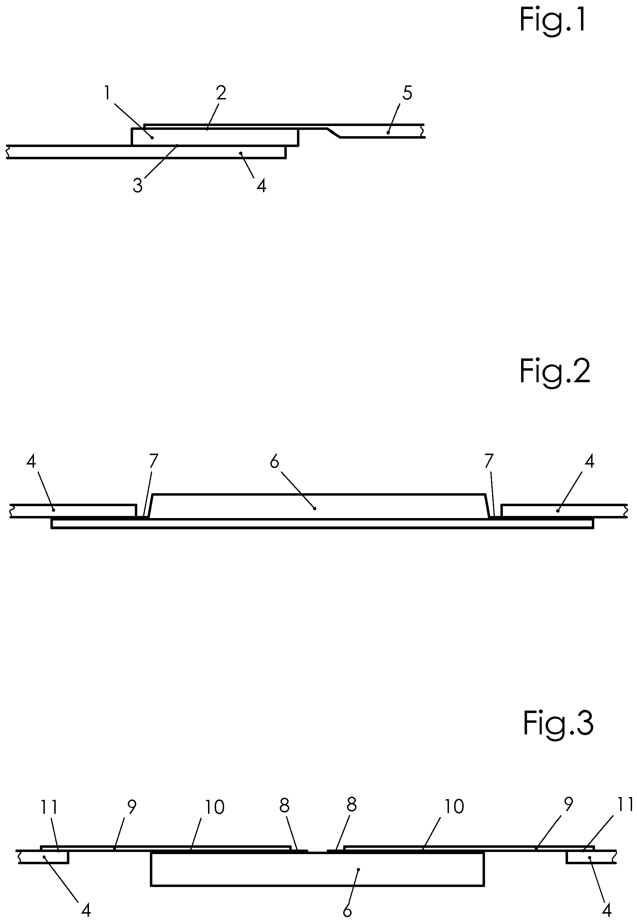

Fig. 1 zeigt im Querschnitt ein sehr dünnes flaches Bypasselement (einen Halbleiter-Diodenchip) 1 mit einer oberen Anschlussfläche 2 auf dem Diodenchip und einer unteren Anschlussfläche 3 unter dem Diodenchip. Die obere Anschlussfläche 2 ist mit einem aufliegenden besonders flachen lötfähigen Querverbinder 5 und die untere Anschlussfläche 3 ist mit einem normalen lötfähigen üblichen Querverbinder 4 kontaktiert. Dieses sehr flach bauende verschaltete Bypasselement 1 ist zwischen einer durchgehend gleichmäßig dick ausgebildeten Frontglasscheibe 1 und Rückglasscheibe 2 einlaminiert (zeichnerisch nicht dargestellt).

Fig. 2 zeigt eine ähnliche Anordnung mit einem dünnen Bypasselement 6, welches als eine Dioden-Ersatzschaltung mit zusätzlicher Kunststoffkapselung ausgeführt ist. Hier sind die Anschlussfahnen 7, seitlich abgestuft ausgeführt auf denen die üblichen normal flachen Querverbinder 7 kontaktiert sind Diese Anordnung kann ebenfalls noch zwischen einer durchgehend gleichmäßig dick ausgebildeten Frontglasscheibe 1 und gleichartiger Rückglasscheibe 2 einlaminiert werden (zeichnerisch nicht dargestellt).

Fig. 3 zeigt dünnes Bypasselement 6 als eine Dioden-Ersatzschaltung ebenfalls mit umhüllender Kunststoffkapselung aber anderer Anschlussart. Die Querverbinder 4 mit der Lötverbindung 11 des Querverbinders sind hier seitlich beabstandet ausgeführt und werden mittels besonders flachen und zugleich biegsamen Anschlussfahnen 9 auf der Oberseite des Bypasselements 6 mit der Lötverbindung des Bypasselement 10 kontaktiert, dessen Anschlussflächen 8 einseitig lötfähig ausgebildet und angeordnet sind. Die Kontakte (zwei einseitig lötfähige Anschlussflächen 8) des Bypasselements 6 sind hier voneinander getrennt nur auf einer Seite durch die Kunststoffkapselung nach außen geführt.

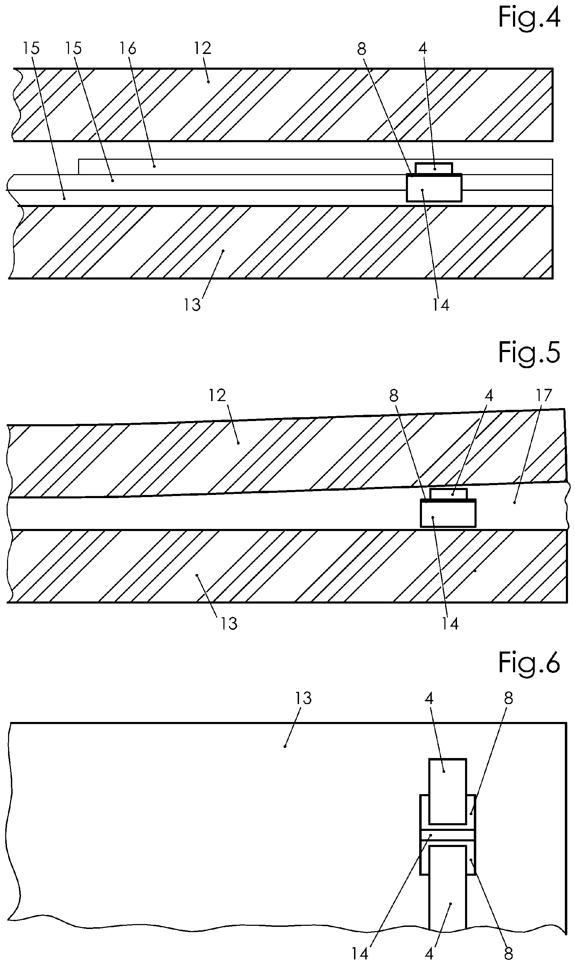

Fig. 4 zeigt einen Querschnitt durch ein gesamtes erfindungsgemäßes Glas-Glas-Solarmodul-Laminat vor dem Laminieren mit einer Einbettungsmateriallage 16 über die gesamte Modulbreite, aber kürzer ausgeführt als die Gesamtlänge des Solarmoduls mit einem geringfügig zu dicken Bypasselement 14, d. h. die Höhe des Bypasselements 14 mit aufliegendem oben kontaktierten Querverbinder 4 und einseitig lötfähiger Anschlussfläche 8 ist größer als die eigentlich durch die Dicke des Einbettungsmaterials vorgegebene und normalerweise gewünschte Spalthöhe zum Beispiel gleich 1,3 mm. Das Bypasselement 14 ist hier in diesem Beispiel in zwei Lagen eines sowohl über die Modulbreite als auch über die Modullänge 14 durchgehenden Einbettungsmaterials 15 eingelegt. Zwischen der Frontglasscheibe 12 und der Rückglasscheibe 13 ist eine weitere verkürzte Lage des Einbettungsmaterials 16 angeordnet.

Dies bewirkt, wie aus Figur 5, welche einen Querschnitt durch ein Glas-Glas-Solarmodul-Laminat nach dem Laminieren mit einer Einbettungsmateriallage 16 über die gesamte Modulbreite aber kürzer ausgeführt als die Gesamtlänge des Solarmoduls zeigt, ersichtlich, dass die Rückglasscheibe 13 und die Frontglasscheibe 12 nach dem Laminieren nicht mehr genau parallel zueinander liegen. Das Einbettungsmaterial 17 nach dem Laminieren bei einem Bypasselement mit erhöhter Dicke ist über die Modulfläche verteilt unterschiedlich dick. Letztlich entsteht hier eine Art leichte Welligkeit der Frontglasscheibe 12, welche den die unterschiedliche Spalthöhen an der Stellen mit zwischen liegenden Bypasselementen 14 und den Zwischenflächen mit geringer Dicke zwischen den beabstandeten Bypasselementen 14 folgt.

Fig. 6 zeigt eine Draufsicht auf eine Ausführung und mögliche Anordnung eines zwischen Fronglasscheibe 12 und Rückglasscheibe 13 gelegten Bypasselements 14 gemäß Figur 4. Hieraus wird ersichtlich, wo insbesondere ein Bypasselement 14 mit einseitig lötfähigen Anschlussflächen 8 und den aufgelöteten Querverbindern 4 im Bezug zum Modulrand in etwa eingelegt ist.

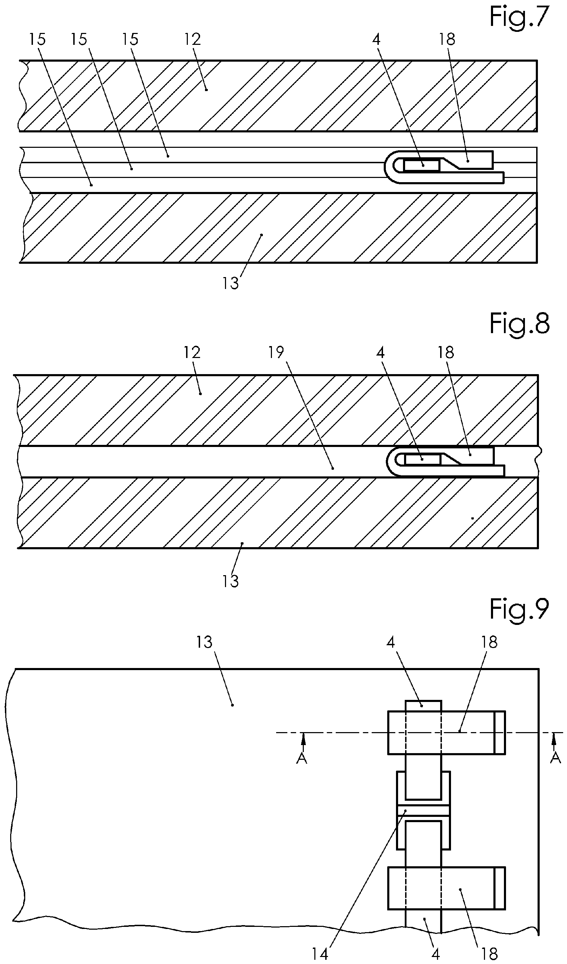

Fig. 7 zeigt die Anordnung eines neuartigen Abstandshalters 18 zur Fixierung der Querverbinder 4 nach dem Auflegen auf eine Rückglasscheibe 13 vor dem Laminieren, eingebettet und umschlossen von drei Lagen Einbettungsmaterial 15. Dadurch wird es möglich alle Querverbinder bzw. Verbindungsleitungen vor und während des Laminierprozesses zuverlässig und unverrückbar zu positionieren.

Fig. 8 zeigt einen neuartigen Abstandshalter 18 nach dem Laminieren anliegend an der Frontglasscheibe 12 und der Rückglasscheibe 13. Die Höhe des Abstandshalters 18, der den Querverbinder 4 umfasst, ist dabei jeweils kleiner gleich der gewünschten Spalthöhe wischen den beiden Glasscheiben 12, 13 nach dem Laminierprozess und entspricht idealerweise auch der Dicke des Einbettungsmaterials 19 nach dem abgeschlossenen Laminierprozess. Die Abstandshalter dienen also neben der zuverlässigen Positionierung der Querverbinder 4 auch der Ausbildung einer gleichmäßigen Spalthöhe und einem möglichst gleichbleibenden Parallelität der Frontglasplatte 12 und der Rückglasplatte 13.

Fig. 9 zeigt eine Draufsicht nach Figur 4 und Figur 6, aus der überblicksmäßig die Anordnung eines Bypasselements 14, die damit verschalteten Querverbinder 4 und die Lage und Anordnung der Abstandselemente 18 ersichtlich ist. Es ist logisch, dass die Querverbinder 4 in gewissen Abständen auch mehrfach wiederholt angeordnet sein können.

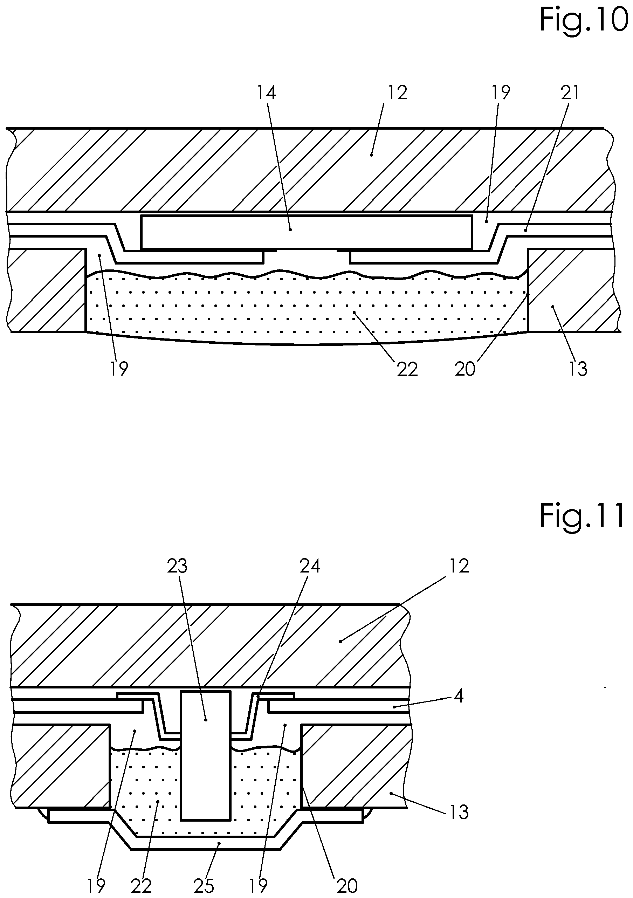

Fig. 10 zeigt ein geringfügig zu dickes Bypasselement 14 und dessen Anordnung in einer zusätzlich eingebrachten Aussparung oder Öffnung 20 in der Rückglasscheibe 13. Das geringfügig zu dicke (d. h. in der Höhe mehr als 1,3 mm) Bypasselement 14 ist mit einseitig lötfähigen Anschlussflächen 8 ausgebildet. Mit diesen Anschlussflächen 8 sind im Bereich der zusätzlich durch die Rückglasscheibe 13 hindurch eingebrachten Öffnung 20 flache lötfähige abgekröpfte Querverbinder 21 verbunden. Dieser Verbund der Querverbinder 21 mit dem geringfügig zu dicken Bypasselement 14 ist in das Einbettungsmaterial 19 nach erfolgtem Laminierprozess fest eingebettet. Die zusätzlich in die Rückglasscheibe 13 eingebrachte Öffnung 20 ist mit einem geeigneten Witterungs- und Klimabeständigen Material dicht verschlossen. Die Enden der flachen lötfähigen abgekröpften Querverbinder 21, die mit den Bypasselementen verbunden sind, kompensieren durch die Kröpfung auftretende möglich thermisch unterschiedliche Ausdehnungen und dienen auch zum eventuellen Abbau eingebrachter mechanischer Spannungen.

Fig. 11 zeigt ein erheblich dickeres Bypasselement 23 und dessen Anordnung in einer zusätzlich eingebrachten Öffnung 20 in der Rückglasscheibe 13. Die flachen Querverbinder 4 sind hier mit den lötfähigen abgekröpften Anschlusspins des Bypasselements 23 verbunden. Dadurch ist es auch möglich bei Bedarf erheblich dickere Bypasselemente 23 einzusetzen, die wegen ihrer Größe sogar durch die zusätzlich eingebrachte Öffnung 20 über die rückseitige Außenfläche der Rückglasscheibe 13 hinausragen können. Der freie Zwischenraum zwischen Einbettungsmaterial 19 im Bereich der Öffnung 20 einschließlich das Bypasselement 23 sind mit einem geeigneten Füllmaterial 22 aus bzw. umgossen. Zusätzlich ist es vorteilhaft, wenn wegen einer höheren Dichtheit eine weitere Abdeckkappe 25 angeordnet und aufgeklebt ist.

In der Regel sind pro Solarmodul zwei Querverbinderleitungen angeordnet in den Querverbindern sind bevorzugt drei Bypasselemente verteilt angeordnet und verschaltet, wobei in zwei Ecken relativ weit außen dann zwei Anschlussdosen mit den entsprechenden Modulanschlusskabeln angeordnet sind. Die Querverbinder sind am Rand des Moduls angeordnet und weisen an jedem Ende einen Kontaktpunkt auf mit dem die Anschlussdosen verbunden sind. Beide Anschlussdosen können relativ klein ausgebildet werden und sind nahe an gegenüberliegenden Modulkanten angeordnet. Diese enthalten bevorzugt keine Bypasselemente. Die Bypasselemente in der Achse der Querverbinder sind thermisch weit voneinander entfernt angeordnet. Ihre Verlustwärme wird entlang der Querverbinder, sowie durch ihre vollständige Einbettung zwischen den beiden Glasscheiben gut abgeleitet. Die Länge aller Leitungen sowohl zwischen den inneren Modulanschlusspunkten als auch zwischen benachbarten Solarmodulen einer Zeile bei Reihenschaltung der Solarmodule kann durch die erfindungsgemäße Lösung weitgehend minimiert werden.

Ein weiterer Vorteil besteht darin, dass es je nach Einsatzfall möglich ist, verschicken Dicke Bypasselemente wie zum Beispiel monolithische oder auch hybride Halbleiter-Dioden-Element mit geringer Flußspannung, mit Anschlussflächen auf nur einer Seite auf verschiedenen Seiten oder gegenüberliegenden Seiten, mit oder ohne Anschlusspins einsetzen zu können. Pro Bypasselement kann die Anzahl der Anschlussflächen auch gegebenenfalls größer als zwei sein.

Die Verbindung der Bypasselemente mit anderen Verbindungselementen erfolgt bevorzugt durch Schweißen, Löten, Kleben oder Klemmen.

Die Verbindung von Bypasselementen mit den flachen Querverbindern erfolgt vorzugsweise durch Löten.

Im Bereich der Bypasselemente kann wahlweise beim Laminieren zusätzliches Einbettungsmaterial zum Dickenausgleich beigefügt werden, falls die eingesetzten Bypasselemente zu dick sind, um Glasbrüche oder Blasenbildung zuverlässig zu vermeiden. Die Öffnung in der Rückglasscheibe für etwas dickere Bypasselemente kann die Form eines Kreises, einer Ellipse, eines Langlochs, Rechtecks oder eine Kombinationen dieser Formen haben.

Die durch das Bypasselement nicht vollständig ausgefüllte Öffnung 20 in der Rückglasscheibe 13 kann vor oder nach dem Laminieren mit Füllmaterial 22 und/oder einem zusätzlichen geeigneten Füllkörper versehen werden.

Deren Abdeckung weist die Form einer Abdeckkappe auf, deren Kappenrand umlaufend geschlossen ausgebildet ist und sich in einer gleichen Ebene befindet. Die Abdeckung besteht bevorzugt aus wetterbeständigem Material, z.B. Metall, Kunststoff, Glas oder Keramik.

### Bezugszeichenliste

- 1: flaches Bypasselement (Halbleiter-Diodenchip)
- 2: obere Anschlussfläche am Diodenchip
- 3: untere Anschlussfläche am Diodenchip
- 4: lötfähiger Querverbinder flach,
- 5: flacher lötfähiger Querverbinder mit abgeflachte Anschlussfahne
- 6: Bypasselement als Dioden-Ersatzschaltung mit Kunststoffkapselung
- 7: seitlich herausgeführte, abgestufte Anschlussfläche
- 8: einseitige lötfähige Anschlussflächen
- 9: biegsame Anschlussfahne (dünner als Querverbinder)
- 10: Lötverbindung zum Bypasselement
- 11: Lötverbindung zum Querverbinder
- 12: Frontglasscheibe
- 13: Rückglasscheibe
- 14: geringfügig zu dickes Bypasselement
- 15: Einbettungsmateriallage über gesamte Modulfläche
- 16: Einbettungsmateriallage über gesamte Modulbreite, kürzer als Gesamtlänge
- 17: Einbettungsmaterial nach Laminieren bei einem Bypasselement mit erhöhter Dicke
- 18: Abstandshalter
- 19: Einbettungsmaterial nach abgeschlossenen Laminierprozess
- 20: Aussparungen oder Öffnungen in der Rückglasscheibe
- 21: flacher lötfähiger abgekröpfter Querverbinder
- 22: Füllmaterial
- 23: dickes Bypasselement
- 24: lötfähiges, abgekröpftes Anschlusspin
- 25: Abdeckkappe

## Patentansprüche

1. Glas-Glas-Solarmodul-Laminat mit innenliegenden Solarzellen, wobei zwischen einer Frontglasscheibe (12) und einer Rückglasscheibe (13) Bypasselemente (1, 6, 14, 23) mit gleicher oder unterschiedlicher Höhe angeordnet sind, weiterhin die Bypasselemente (1, 6, 14, 23) Querverbinder (4, 5, 7) aufweisen, welche mit Anschlussflächen (2, 3) eines Diodenchip (1) kontaktiert sind, und mit wenigstens zwei, am Modulrand angeordneten Anschlussdosen,
**dadurch gekennzeichnet, dass**
Abstandshalter (18) vorgesehen sind, welche den jeweiligen Querverbinder (4) umfassen, wobei die Höhe des Abstandshalters (18) gleich oder kleiner als die Spaltbreite zwischen der Frontglas- und der Rückglasscheibe (12; 13) nach dem Laminierprozess ist, wobei die Abstandshalter(18) sowohl der Positionierung der Querverbinder (4) als auch der Ausbildung einer gleichmäßigen Spalthöhe und möglichst gleichbleibender Parallelität zwischen der Frontglasscheibe (12) und der Rückglasscheibe (13) dienen.

2. Glas-Glas-Solarmodul-Laminat nach Anspruch 1,
**dadurch gekennzeichnet, dass**
bei einer Dicke der Bypasselemente (14, 23) von größer 1,3 mm in der Rückglasscheibe (13) zusätzliche Aussparungen oder Öffnungen (20) angeordnet sind, in denen die zu dicken Bypasselemente (14, 23) angeordnet und kontaktiert sind.

3. Glas-Glas-Solarmodul-Laminat nach Anspruch 2,
**dadurch gekennzeichnet, dass**
zusätzliche Aussparungen (20) nur an der Innenseite der Rückglasscheibe (13) als nicht nach außen durchgehende Aussparungen ausgebildet sind.

4. Glas-Glas-Solarmodul-Laminat nach Anspruch 2 oder 3,
**dadurch gekennzeichnet, dass**
weitere Aussparungen (20) an der Innenseite der Frontglasscheibe (12) als flächige, beliebig geformte, nicht nach außen durchgehende Aussparungen (20) ausgebildet sind.

## Claims

1. Glass-glass solar module laminate with internal solar cells, wherein, between a front glass panel (12) and a rear glass panel (13), bypass elements (1, 6, 14, 23) of the same or different heights are provided, furthermore the bypass elements (1, 6, 14, 23) comprise cross connectors (4, 5, 7) contacted to connecting surfaces (2, 3) of a diode chip (1), and with at least two junction boxes arranged at the module edge,
**characterized in that**
spacers (18) are provided embracing the respective cross connector (4), wherein the height of the spacer (18) is equal to or less than the gap width between the front glass panel and the rear glass panel (12; 13) after the laminating process, wherein the spacers (18) serve the purpose of both positioning the cross connectors (4) and forming a uniform gap height and a preferably constant parallelism between the front glass panel (12) and the rear glass panel (13).

2. Glass-glass solar module laminate according to claim 1,
**characterized in that**
at a thickness of the bypass elements (14, 23) of more than 1.3 mm, additional recesses or openings (20) are arranged in the rear glass panel (13), in which the bypass elements (14, 23) that are too thick are arranged and contacted.

3. Glass-glass solar module laminate according to claim 2,
**characterized in that**
additional recesses (20) are only formed at the inside of the rear glass panel (13) as recesses that are not going through to the outside.

4. Glass-glass solar module laminate according to claim 2 or 3,
**characterized in that**
further recesses (20) are formed at the inside of the front glass panel (12) as planar recesses (20) of a desired shape and not going through to the outside.

## Revendications

1. Stratifié de module solaire de type verre-verre avec cellules solaires situées à l'intérieur, dans lequel des éléments de by-pass (1, 6, 14, 23) avec des hauteurs égales ou différentes sont agencés entre une plaque de verre frontale (12) et une plaque de verre dorsale (13), dans lequel les éléments de by-pass (1, 6, 14, 23) comportent en outre des éléments de liaison transversaux (4, 5, 7), lesquels viennent en contact avec des surfaces de connexion (2, 3) d'une puce à diode (1), et comprenant au moins deux prises de connexion agencées à la bordure du module,
**caractérisé en ce que**
il est prévu des éléments d'écartement (18), qui incluent les éléments de liaison transversaux (4) respectifs, dans lequel la hauteur de l'élément d'écartement (18) est égale ou inférieure à la largeur de l'intervalle entre la plaque de verre frontale et la plaque de verre dorsale (12 ; 13) après le processus de stratification, dans lequel les éléments d'écartement (18) servent à la fois au positionnement des éléments de liaison transversaux (4) et à la formation d'une hauteur d'intervalle régulière et un parallélisme aussi constant que possible entre la plaque de verre frontale (12) et la plaque de verre postérieure (13).

2. Stratifié de module solaire de type verre-verre selon la revendication 1,
**caractérisé en ce que**, pour une épaisseur des éléments de by-pass (14, 23) supérieure à 1,3 mm, des évidements ou des ouvertures supplémentaires (20) sont ménagé(e)s dans la plaque de verre postérieure (13), dans lesquels/lesquels les éléments de by-pass (14, 23) trop épais sont agencés et amenés en contact.

3. Stratifié de module solaire de type verre-verre selon la revendication 2,
**caractérisé en ce que** des évidements supplémentaires (20) sont réalisés uniquement sur la face intérieure de la plaque de verre postérieur (13), sous forme d'évidements qui ne traversent pas vers l'extérieur.

4. Stratifié de module solaire de type verre-verre selon la revendication 2 ou 3,
**caractérisé en ce que** d'autres évidements (20) sont réalisés sur la face intérieure de la plaque de verre frontale (12), sous forme d'évidements surfaciques (20) de conformation quelconque qui ne traversent pas vers l'extérieur.
